# EUROPEAN PATENT SPECIFICATION

(11) **EP 2 283 523 B1**
(45) Date of publication and mention of the grant of the patent: **30.10.2013**
(21) Application number: 09732833.0
(22) Date of filing: 16.04.2009
(51) Int. Cl.: H01L 31/18, H01L 31/20

(54) **ASSEMBLY LINE FOR PHOTOVOLTAIC DEVICES**
FERTIGUNGSSTRASSE FÜR FOTOVOLTAIKANORDNUNGEN
LIGNE D'ASSEMBLAGE POUR DISPOSITIFS PHOTOVOLTAÏQUES

(30) Priority: 18.04.2008 US 46115 P
(43) Date of publication of application: 16.02.2011
(73) Proprietor: TEL Solar AG, 9477 Trübbach (CH)
(72) Inventor: HUEGLI, Andreas, CH-7212 Seewis (CH); KOEPFLI, Reto, CH-8880 Walenstadt (CH); ROSCHEK, Tobias, CH-9470 Buchs-SG (CH); SCHWARZENEGGER, Bernd, A-6972 Fussach (AT); UNGAR, Adolf, CH-8887 Mels (CH); KLUTH, Oliver, CH-8880 Walenstadt (CH); MOHR, Michael, CH-7304 Maienfeld (CH)
(74) Representative: Michalski Hüttermann & Partner Patentanwälte
(86) International application number: PCT/EP2009/054568
(87) International publication number: WO 2009/127709

(56) References cited:
- WO-A1-03/067671

## Description

### Technical Field

The present invention relates to the field of thin-film manufacturing and photovoltaic devices. Particularly, the present invention discloses a method for the production of thin-film silicon-based solar cells or modules.

### Background Art

Photovoltaic devices, photoelectric conversion devices or solar cells are devices which convert light, especially sunlight into direct current electrical power. For low-cost mass production thin-film solar cells are being of interest since they allow using glass, glass ceramics or other rigid or flexible substrates as a base material, i.e. a substrate, instead of crystalline or polycristalline silicon. The solar cell structure, i.e. the layer sequence responsible for or capable of the photovoltaic effect is being deposited in thin layers. This deposition may take place under atmospheric or vacuum conditions. Deposition techniques are widely known in the art, such as PVD, CVD, PECVD, APCVD, or MOCVD all being used in semiconductor technology.

Today, thin-film photovoltaic cells are heading for mass-production. A main requirement for such mass production is an integrated manufacturing process that allows the efficient and effective manufacturing of such cells.

Document WO 03/067671 A disclose a method to manufacture solar cells.

### Summary of invention

It is an object of the present invention to provide a method according to claim 1 and a system according to claim 15 for the production of thin-film photovoltaic devices, such as solar cells, with an improved yield, throughput, uptime and/or quality.

This object is achieved by a method and a system according to the independent claims. Preferred embodiments are given in the dependent claims.

In a further preferred embodiment the method for the production of a thin-film photovoltaic device comprises the steps of: a) Providing at least one substrate comprising a front contact; b) Depositing at least a first semiconductor stack onto the substrate to produce a photo-voltaic device; and comprising at least three, four, five or all of the steps of: c) Applying a back contact to the photovoltaic device; d) Contacting of the photovoltaic device; e) Removal of unnecessary material from the edge regions of the photovoltaic device; f) Encapsulation of the photovoltaic device; g) Cross-contacting the photovoltaic device; and h) Framing of the photovoltaic device, wherein the substrate is continuously or semi-continuously moved from one step of the method to the next step of the method. The continuous or semi-continuous movement of the substrate from one step of the method to the next step of the method has the advantage that an improved yield, throughput, uptime and/or quality of the produced thin-film photovoltaic device can be achieved.

Accordingly, it is an essential idea of the invention to continuously or semi-continuously move the substrate along an assembly line to achieve a high standardization starting with the point of delivery of the substrate from a supplier to delivery of the finished photovoltaic device.

The term "continuous" as used herein is meant to refer to a process whereby the substrate continuously moves along, for example on a belt, on rollers, jig, moving framework, or other means for conveying the substrate from one operation or step in the process to the next operation or step. The means for conveying the substrate can comprise two or more different ways of conveying the substrate. The substrate can move horizontally or vertically, or nearly vertically (e.g. +/-10° from vertical) through the process.

The process of this invention comprises continuous steps implying that the means for conveying the substrate conveys the substrate to and through each step or individual operation in the overall process. Other steps can be completed in a manner isolated from the rest of the processes or in what is many times referred to as a batch-type of process step with several substrates being subjected to essentially the same process conditions in parallel. When one or more - but not all - process steps are conducted so that it is isolated from the rest of the process steps, the overall process is referred to herein as a "semi-continuous" process.

An inline-process describes in this context is a sequence of process steps performed in dedicated process stations, carried out with essentially the same set of process parameters or completely different ones, which are being subsequently addressed by a substrate. In contrast to the continuous process an inline process will be performed in a common process environment, like one process system, e. g. under vacuum conditions.

The photovoltaic device can be any photovoltaic device known to the skilled person. A photovoltaic device is a device which converts light, especially sunlight, into direct current (DC) electrical power. In specific embodiments of the invention the photovoltaic device is photoelectric conversion devices or, preferably, a solar cell. More preferably, the solar cell is a thin-film solar cell.

A thin-film solar cell generally comprises a first electrode - also known as front contact, one or more semiconductor thin-film p-i-n junctions, i.e. absorber layer(s), and a second electrode - also known as back contact, which are successively stacked on a substrate. Each p-i-n junction or thin-film photoelectric conversion unit comprises an i-type layer sandwiched between a p-type (positively doped) layer and an n-type (negatively doped) layer. The i-type layer, which is a substantially intrinsic semiconductor layer, occupies the most part of the thickness of the thin-film p-i-n junction. Photoelectric conversion occurs primarily in this i-type layer.

The skilled person knows further designs of photovoltaic cells, all of which are meant to be encompassed by the present invention. Basically, three designs of the absorber layer in thin-film cells are currently known: heterojunction devices, pin and nip devices, and multijunction devices. The heterojunction device is often chosen to produce cells which are made of thin-film materials that absorbed light much better than silicon. In heterojunction devices the junction is formed by contacting two different semiconductors, e.g. CdS and CulnSe₂. The top layer, or "window" layer, of a heterojunction device is a material with a high band gap selected for its transparency to light. Thus, almost all incident light is allowed to reach the bottom layer, which is produced of a material with low band gap that readily absorbs light. This light then generates electrons and holes very near the junction, thus effectively separating the electrons and holes before they can recombine. An example for a heterojunction device is a CIS or a CIGS cell. Positively doped, intrinsic, negatively doped semiconductor (pin) and negatively doped, intrinsic, positively doped semiconductor (nip) devices are built-up as a three-layer sandwich with a middle intrinsic (i-type or undoped) layer between an n-type layer and a p-type layer. An example for a pin device is a pin amorphous silicon (a-Si) cell, comprising a p-type a-Si:H layer, a middle layer of intrinsic Si:H, and an n-type a-Si:H layer. An example for a nip device is a CdTe cell, whose structure is similar to the a-Si cell, except the order of layers is flipped upside down. In a typical CdTe cell, the top layer is p-type cadmium sulfide (CdS), the middle layer is intrinsic CdTe, and the bottom layer is n-type zinc telluride (ZnTe).

Multijunction cells consist of multiple thin-films usually produced using molecular beam epitaxy and/or metalorganic vapour phase epitaxy. In a typical multi junction device, individual cells with different band gaps are stacked on top of one another, wherein the individual cells are stacked in such a way that the light falls first on the material having the largest band gap. Photons not absorbed by the first cell are transmitted to the second cell which then absorbs the higher-energy portion of the remaining radiation, while remaining transparent to the lower-energy photons. These selective absorption processes continue through to the final cell, which has the smallest band gap. Multi junction devices are also known as tandem cells.

In specific embodiments of the invention, the absorber layer of the solar cell is that of a heterojunction device, a pin device, a nip device or, preferably a multijunction device, i.e. a tandem device. In further embodiments the absorber layer consists of a material selected from the group consisting of: amorphous silicon (a-Si), microcrystalline silicon (µ-Si), nanocrystalline silicon (n-Si), combinations of a-Si, µ-Si and n-Si, CdTe, and CuIn(Ga)Se₂. In a preferred embodiment of the invention the absorber layer comprises µ-Si that shows no or almost no light-induced degradation and also allows capturing light of longer wavelength which leads to an enhanced efficiency of the solar cell. In further specific embodiments the silicone is hydrated silicone (Si:H), for example a-Si:H, µ-Si:H or n-Si:H. The silicone can further comprise carbon, e.g. SiC:H.

Depending on the crystallinity of the i-type layer, solar cells or photoelectric (conversion) devices are characterized as amorphous (a-Si) or microcrystalline (µc-Si) solar cells, independent of the kind of crystallinity of the adjacent p and n-layers. As used herein, microcrystalline layers are meant to be layers comprising at least 50% and preferably >60% of microcrystalline crystallites in an amorphous matrix.

In a preferred embodiment, the thin-film solar cell is a tandem cell, i.e. a tandem junction solar cell. As explained above, in tandem cells a first photoelectric conversion unit with sensitivity in a first wavelength spectrum is combined with a second photoelectric conversion unit with sensitivity in a second wavelength spectrum. In a further preferred embodiment, an a-Si cell having sensitivity in a shorter wavelength spectrum is combined with a µc-Si cell utilizing the longer wavelengths of the impinging spectrum. This has the advantage that an increased efficiency of the photovoltaic device is achieved.

The substrate can be any substrate suitably for the production of thin-film photovoltaic devices. In specific embodiments of the invention the substrate is a translucent substrate that can be subjected to vapor deposition techniques. Preferably, the substrate is selected from the group consisting of glass, ceramics, glass-ceramics, security glass, quartz glass, float glass or other glass-like material, a flexible translucent material, plastic such as polyimide, and/or a metal film such as aluminum, steel, titanium, chromium, iron and the like. Glass, particularly a highly transparent or transmissive glass is preferred. In another embodiment of the invention the substrate comprises an antireflexion coating so that the amount of incident light reaching the absorber layer is increased.

The substrate can be of any size and/or shape provided it can fit into the processing equipment used in the process of this invention. If larger substrate sizes are desired, the processing equipment as described herein will need to be sized accordingly. Preferably, the substrate has a size of 1.4 m², more preferably the substrate has the dimensions of 1.1 m x 1.3 m. In another preferred embodiment the substrate is of flat, rectangular and/or square shape. Such preferred sizes and shapes have the advantage that a high standardization is possible as such substrates are readily available and furthermore are well suited for architectural purposes.

In a first step according to the method of the invention a substrate is provided comprising a front contact. Preferably, the substrate is obtained from a supplier and inspected visually for defects such as correct glass dimensions, rectangularity, flatness, edge cracks, scratches, inclusions. In another preferred embodiment the substrate is supplied in the desired size, shape and/or heat treated with the edges seamed to enhance the strength of the glass. Optionally, the substrate can be supplied without such treatment and the first steps of the process of this invention would be to seam the edges, to provide for crack resistance and/or to eventually heat strengthen the substrate. The heat strengthening procedure can take place either before or after the seaming procedure. Preferably the heat strengthening is conducted after the seaming of the glass. Another step that may be carried out in the process is a rough washing to remove remains from the edge seaming process, e. g. by gases or water.

In a further embodiment the substrate is acquired already with a front electrode applied to it, e.g. glass type Asahi VU. The front electrode preferably comprises a transparent conductive oxide (TCO), such as ZnO, SnO, SnO₂ and/or indium-tin oxide (ITO) or others. The TCO layer(s) may be doped, e.g. with fluorine, aluminum, gallium, boron and/or the like. In case such a substrate is used, a quality check of said TCO layer is preferably performed. This may, preferably be done as a hand held four point probe, resistance check and/or visually.

After these initial preparations the substrate is preferably loaded into a movable container as explained below.

The substrate may be subjected to an additional cleaning - preferably fine cleaning - step before entering the front end clean room area of the substrate treatment system.

If substrate is acquired that has not yet a front electrode applied to it, this is carried out in a first step in the substrate treatment system to provide a substrate comprising a front contact. Optionally, the substrate is washed and dried before the front contact is deposited. In a preferred embodiment a further prior quality check is carried out to ensure that the substrate is clean, without scratches and/or pinholes. After these initial preparations the substrate is preferably loaded into a movable container as explained below and moved along for the deposition of the front contact.

Preferably the substrate is heated at atmospheric or reduced pressure to the desired process temperature before it enters the process chamber for the deposition of the front contact.

Prior to the deposition of the front contact onto the substrate, silicon dioxide or other transparent dielectric substances can be deposited onto the substrate. Alternatively, precoated glass substrates are available equipped already with such a barrier layer. The dielectric substance, if applied, is generally deposited in a layer about 10 nm to about 200 nm.

In a preferred embodiment of the invention the front contact, preferably a TCO, is deposited in a vapor deposition process module by vapor deposition. The deposition may take place under atmospheric or vacuum conditions. Preferably the process module is a chemical vapor deposition (CVD) or physical vapor deposition (PVD) module for sputtering a metal oxide target or a metal target in an oxygen atmosphere. More preferably, the process module is low pressure CVD (LPCVD), plasma enhanced CVD (PECVD), an atmospheric pressure CVD (APCVD) and/or a metal-organic CVD (MOCVD) module. LPCVD of, for example, zinc oxide can be accomplished by directing at the substrate a mixture of a reactive zinc compound such as a dialkyl zinc, for example, diethyl zinc, and an oxidizer like water and/or alcohols, optionally in the presence of a dopant such as diborane. The reactive zinc compound reacts with the water to form zinc oxide in situ and is deposited on the substrate. In another preferred embodiment the process module is used for thin-film deposition, more preferably for ZnO thin-film deposition. The front contact may comprise one or more layers of a suitable transparent conductive material as explained above.

In a preferred embodiment the morphology of the TCO layer is a textured morphology with uneven surface features resulting in a scattering into the adjacent semiconductor layers thereby increasing the effective travel path for the light, which again results in increased probability of absorption. Such textured surface thereby advantageously improves the efficiency of a respective photovoltaic device. Suitable texturing can be achieved by using an acid etch process such as by exposing the TCO layer to a diluted aqueous solution of hydrofluoric acid at a concentration of about 0.1 to about 1 weight percent acid, for about 15 to about 20 seconds, at about room temperature followed by a thorough rinsing with water to remove residual acid. Alternatively the texturing of the TCO layer is accomplished by ion etching. This can be accomplished, inter alia, by argon ion etching, alternatively by reactive ion etching with carbon tetrafluoride, oxygen or like compound or element which is used to form a reactive plasma atmosphere to plasma etch the TCO layer to achieve the desired morphology of the layer.

At this stage a cleaning step by water or purified water and/or organic detergents can preferably be carried out in order to remove deposition particles that may later possibly result in shunts which can interfere with the further post-treatment processing, e. g. laser patterning.

In an especially preferred embodiment of the invention the textured front contact morphology is achieved by appropriately adjusting the process parameters during deposition of the front contact. This has the advantage that above-mentioned post-treatment steps for the front contact can be omitted and thus process time and required further additional equipment can be saved. Moe preferably, the deposition is conducted at a deposition rate of about 1 nm per second to about 9 nm per second, preferably about 2 nm per second to about 4 nm per second. In another preferred embodiment the deposition of the front contact layer onto the substrate is carried out at a temperature of about 100° C to about 300° C and/or at a pressure of about 0.2 hPa to about 2 hPa. In an even more preferred embodiment of the invention the process is carried out using an inline TCO deposition system commercially available as TCO 1200 system from Oerlikon Solar. In this inline system the substrate moves under stationary sources depositing the front contact material.

In another embodiment of the invention further quality checks are carried out after the deposition of the front contact - and possible post-treatments - to ensure that the haze, thickness and/or resistivity of the front contact are within the specifications.

The substrate comprising the front contact may then be moved on to a first treatment module - preferably a laser treatment module - wherein the front contact is divided or patterned to provide for a collection of individual photovoltaic cells of the photovoltaic module. A photovoltaic module is a collection of individual cells connected, typically, in series to achieve the desired voltage for the module. The dividing of the front contact is preferably accomplished by removing strips of the deposited front contact. For example, these strips or scribes can have a width of about 10 µm to about 100 µm, preferably from about 20 µm to about 50 µm. The spacing of these strips will determine the width of the individual cells on the photovoltaic module. Preferably, the strips are parallel to one another, straight, and/or parallel to one edge of the substrate.

In order to form these strips in the front contact, the front contact material can be removed by any suitable method such as chemical etching, laser ablation, mechanical stylus, wet or dry etch, a lift-off method and/or water jet ablation. Preferably, the removal of the front contact material is conducted at ambient temperature and/or under atmospheric conditions.

Preferably, the front contact material is removed by laser scribing, wherein one or more laser beams are directed at the substrate and scanned across the surface of the front contact material thereby removing the front contact material in the desired pattern. The laser selected as well as the wavelength of the laser light, the pulse-width of the laser, the laser beam shape and/or the repetition rate are selected to efficiently remove the front contact in the region of the strips. In a preferred embodiment of the invention the laser is preferably an excimer, e.g. ArF, XeCl, XeF, KrF, ArCl, or a solid state, e.g. Nd:YAG, Nd:YLF or Nd:YVO₄, laser. More preferably, the laser is operating at a wavelength of about 190 nm to about 1.200 nm. Even more preferably, the front contact processed by such a laser comprises zinc oxide. Commercially available optics can be used to shape the laser beam to the desired shape. For this laser-scribing step, the laser mechanism is protected from the ambient environment.

In an especially preferred embodiment the module used for the laser treatment of the front contact is a LSS 1200, a system commercially available from Oerlikon Solar.

A cleaning step may take place for the substrate after the removal of the front contact material. The cleaning may be applied on the substrate as a whole or during removal of the front contact material, e.g. by laser scribing, itself, e. g. using a stream of air directed to the spot where the laser is focused on.

Preferably a further quality check allows controlling the accuracy of the removal of the front contact material. Preferably this is carried out on the fly, e. g. by means of a camera following the pattern removed during processing, or alternatively after the process. The pass/fail result will preferably be used for rework-measures. If the measuring result is available during or shortly after the processing of the front contact the substrate needs not to be unloaded from the front contact material removal module. Instead areas not fulfilling the specifications can be immediately addressed.

In a further preferred embodiment an additional quality check is performed wherein the resistance between two patterned areas is measured. This way, it can be determined whether the removal of front contact material resulted in an electrical insulation of the respective cell areas.

In a further embodiment of the invention the substrate comprising the front contact is moved to a module for the deposition of a silicon-containing thin-film, i.e. a module for the deposition of at least a fist semiconductor stack onto the substrate. By this step, a photovoltaic device is produced. Preferably, prior to this deposition step(s) a substrate cleaning step is carried out to achieve an almost perfectly clean substrate surface. Preferably, especially the cleanliness between the patterned areas is being checked, since these areas will be coated again in the following steps.

As the thin-film photovoltaic device is preferably a tandem thin-film photovoltaic device, preferably at least a first and a second semiconductor stack are deposited, wherein the first semiconductor stack is an amorphous semiconductor stack and the second semiconductor stack is a microcrystalline semiconductor stack

The following will describe the application of the first semiconductor layer stack, which preferably is an amorphous semiconductor stack. It will be apparent to the skilled person how to deposit additional semiconductor stacks.

This amorphous semiconductor stack comprises p-i-n or n-i-p amorphous silicon thin film layers. As used herein, p-i-n means that the p-layer of the p-i-n junction is deposited first followed by the i- and then the n-layers. Conversely, for a n-i-p junction, the n-layer that is deposited first followed by the i- and the p-layer.

The amorphous silicon containing thin-film semiconductor preferably comprises hydrogenated amorphous silicon, hydrogenated amorphous silicon carbon and/or hydrogenated amorphous silicon germanium.

For the formation of a p-i-n junction, the positively doped amorphous silicon p-layer of the amorphous silicon semiconductor is deposited on the TCO front contact. The p-layer can be positively doped with diborane (B₂H₆), BF₃ or trimethylboron (TMB) and/or other boron-containing compounds. An undoped amorphous silicon active intrinsic i-layer can be deposited on the p-layer and a negatively doped amorphous silicon n-layer is deposited on the i-layer. The n-layer deposited on the i-layer can comprise amorphous silicon carbon or amorphous silicon negatively doped with phosphine (PH₃) or some other phosphorous-containing compound.

Preferably, the p-type layer has a thickness in the order of about 3 nm to about 25 nm. The intrinsic layer preferably has a thickness in the order of about 100 nm to about 500 nm. The n-type silicon layer preferably has a thickness of about 3 nm to about 50 nm, preferably about 10 nm to about 30 nm.

In a further preferred embodiment an intermediate layer, more preferably a thin dielectric layer, e.g. SiO₂ deposited by means of a PECVD module, is deposited on top of the a-Si layer stack. This has the advantage that the optical and electrical behavior of the resulting tandem cell can be further improved.

In a further embodiment of the invention a second semiconductor layer stack, preferably a microcrystalline semiconductor layer stack is deposited. This stack may again comprise p-i-n or n-i-p silicon thin-film layers. The silicon containing thin-film semiconductor stack preferably comprises hydrogenated microcrystalline silicon, hydrogenated microcrystalline silicon carbon or hydrogenated microcrystalline silicon germanium. For the formation of a p-i-n junction, the positively doped microcrystalline silicon player of the microcrystalline silicon semiconductor is deposited on the previously deposited a-Si layer stack or the intermediate layer as mentioned above. The p-layer can preferably be positively doped with diborane (B₂H₆), BF₃ or other boron-containing compounds. Preferably, a microcrystalline silicon, undoped, active intrinsic i-layer is deposited on the p-layer and a negatively doped microcrystalline silicon n-layer is deposited on the i-layer. The n-layer positioned on the i-layer can comprise microcrystalline silicon carbon or microcrystalline silicon negatively doped with phosphine (PH₃) or some other phosphorous-containing compound.

The p-type layer preferably has a thickness in the order of about 3 nm to about 50 nm, more preferably about 10 nm to about 30 nm. The intrinsic layer preferably has a thickness in the order of about 500 nm to about 2.5 µm, more preferably between about 1 µm and about 2 µm. The n-type silicon layer preferably has a thickness of about 5 nm to about 50 nm, preferably between about 10 nm to 30 nm. More preferably, an n-type dopant, such as phosphine is added to, for example, a silane feed.

In a preferred embodiment, the deposition of the semiconductor stack(s) is carried out according to a batch principle, i.e. the simultaneous processing of more than one substrate at the same time. Even more preferably, the deposition of said p-i-n junction in a manufacturing process according to the invention is accomplished by use of a KAI 1200 PECVD system commercially available from Oerlikon Solar. This system is construed according to the batch principle with up to 3 stacks, each stack accommodating up to 20 substrates with a size of 1.1 m x 1.3 m. Preferably, all substrates in a stack, i.e. a batch, are being processed in parallel.

All appropriate deposition techniques, preferably those mentioned above can be used. More preferably, PECVD is used for depositing thin-film silicon layers. This can be achieved in a system following the single substrate processing approach, e.g. a cluster tool. Designs with single process chambers accommodating several substrates as well as multiple chamber approaches as well as combinations thereof are known in the art. Alternatively low pressure CVD (LPCVD) can be used. Other methods or techniques for depositing the amorphous layers include deposition using electron cyclotron resonant microwaves, hot wire CVD, cascaded arc plasmas, dc hollow cathode, tuned antenna microwaves, or RF hollow cathode. One or more sputtering techniques (PVD) can also be used to apply the amorphous semiconductor silicon layers having a p-i-n or n-i-p junction. Depending on the method used to deposit the amorphous layers different feeds can be used. For example, for the glow discharge type of methods, silane and silane/hydrogen mixtures can be used. With PVD, solid silicon along with argon/hydrogen mixtures can be used. For the hollow cathode technique, a silicon target and silane, or silane and hydrogen can be used.

In a further preferred embodiment of the invention a subsequent quality check is performed after the deposition of a semiconductor stack, to measure the thickness uniformity of the deposited stack(s) and/or to detect shunts.

In another embodiment the invention the method further comprises a step of enabling the later contacting between the patterned front contact and the later applied back contact by removing all layers except for the front contact in a specific pattern. This removal is preferably carried out in a strip- or point-like pattern. As described above, the removal of the material can be achieved by any suitable means, preferably by use of a laser, i.e. a second laser patterning step. Importantly, the front contact is preferably not affected by this removal step.

In a preferred embodiment a laser scribe is carried out. This is being achieved by choosing an appropriate wavelength of the scribing laser and/or selecting appropriate laser pulses and/or pulse energy. Size and design of those removal patterns will be chosen such that appropriate contacting properties can be realized. In a preferred embodiment the removal of the material is achieved by laser machined spots with a diameter of about 30 µm in a row and/or spaced apart up to 60 µm.

As described above for the patterning of the front contact, preferably a cleaning step, a quality check and/or a reworking-step may be carried out after this removal step.

In another embodiment the method according to the invention further comprises the step of applying a back contact to the photovoltaic device. The back contact serves as the counter electrode of the photovoltaic device. The back contact is preferably deposited on top of the silicon layers. In a preferred embodiment the back contact is a transparent conductive oxide as described above comprising, e.g. zinc oxide, tin oxide, and/or indium-tin oxide. The back contact preferably has a thickness of about 60 nm to about 200 nm.

The back contact can be deposited by any suitable means. In a preferred embodiment the back contact is deposited using the deposition techniques and/or process parameters described above for the front contact. Most preferably, the back contact is deposited by a TCO 1200 LPCVD system available from Oerlikon Solar.

In another embodiment of the invention the back contact is a metallic back contact that is preferably applied by sputtering, evaporation or other means. Such a metal back contact advantageously combines the function of a back reflector and back contact.

In a further embodiment a quality check step is carried out after the deposition of the back contact.

In another embodiment of the invention the method further comprises the step of removing strips of the back contact and the silicon layers, e.g. the amorphous, microcrystalline and/or interlayer, parallel to the strips formed in the front contact. This can be carried out by any suitable means, preferably by means as described above, more preferably by a third laser patterning step, i.e. a third laser scribe step of the layer stack. Preferably, the front contact layer is not affected by this further step. Preferably, control of the patterning and/or cleaning during and/or after the patterning step is achieved as described for the previous patterning steps.

In a further embodiment of the invention the method comprises an additional step of shunt busting and/or healing. Due to imperfections in the manufacturing process shunts may be formed leading to a short circuit between different layers which may render the affected cell inoperable. Such shunt can be cured by a method called shunt busting, which is known in the art. After identifying affected cells a healing process can be initiated and the accordingly treated cell will be further processed after appropriate further tests.

In a further preferred embodiment the method comprises an additional quality check, wherein the open circuit voltage (VOC) is checked. For this purpose the substrate is preferably illuminated by light, e.g. by placement on a light table, and VOC generated this way is measured.

In another embodiment the method of the present invention further comprises the step of contacting of the photovoltaic device. The contacting of the photovoltaic device is achieved by applying a conductive strip or strips, also called bus bars, which function as electrical conduits from the photovoltaically active portions of the photovoltaic device, so that the photovoltaic device can be connected to the device or system using the electric current generated by the photovoltaic device. Preferably, the bus bar(s) lead(s) to a central location on the substrate.

Depending on whether the back contact is a TCO or a metal back contact different processing steps are carried out to contact the photovoltaic device.

In one embodiment the back contact is a TCO and, in a first step of the contacting, a conducive adhesive is dispensed on the respective area of the photovoltaic device. Preferably, the adhesive comprises conductive particles, more preferably nano particles, such as a silver glue. Optionally the adhesive may be conditioned, e.g. dried, heated or treated otherwise. Afterwards (a) conductive ribbon(s) is arranged on the adhesive. In a preferred embodiment the conductive ribbon comprises copper and/or is coated with silver, zinc, etc. In another embodiment instead of the ribbons a commercially available fritted conductive paste is applied to form conductive strips. The conductive paste preferably comprises a fritted metal such as silver, copper, tin, nickel, antimony or combinations thereof. The paste also typically comprises an organic solvent that will evaporate when heated and one or more organic binders which will burn or evaporate when the paste is heated to a sufficiently high temperature. The fritted paste can be deposited in a desired pattern by a suitable paste-dispensing machine, by an ink-jet printer or by screen printing. Preferably, a curing step is additionally carried out to create a close contact to the back contact. This can be achieved by locally heating up the contact area with infrared radiation, induction heating and/or convection.

In a preferred embodiment a subsequent quality check is carried out to check if the contacting is complete. The quality check may comprise a visual inspection to determine if any lift-ups of the contact ribbon can be detected due to incomplete contacting.

In a preferred embodiment a reflector is being placed upon the back contact including the contact ribbons in a further step. This reflector can be made of any suitable material. Preferably the reflector comprises white pigments, such as white paint. In a further preferred embodiment the reflector is applied by a screen printing method, by spraying and/or other dispensing methods. The applied reflector material is preferably a UV curable material and/or solvent based. Typically, a curing step of the applied reflector material is additionally carried out in order to accelerate processing. Preferably such a curing step comprises exposing to UV light, heat and/or vacuum. A vacuum assisted outgassing of solvent based reflector material can utilize a measurement of solvent concentration in the reflector material and/or the exhaust air as endpoint detection means. In preferred embodiments the curing is carried out in curing ovens and/or drying stations, more preferably vacuum assisted. The contacting is preferably concluded by a subsequent quality check to ensure that the specifications in terms of reflectance, positioning of the reflector and its optical density are being met. A visual inspection will be the preferred measure.

In another embodiment of the invention the back contact is a metal back contact and different contacting steps apply. For a metal back contact the contacting can be realized by soldering, and/or welding an external wire to the ends of conductive strips or bus bars. Alternatively, an electrical connector is applied to the ends of conductive strips or the bus bars. Such conductive strips or bus bars can be a made of any suitable electrically conductive material and/or can be of any suitable shape such as for example a flat tape. Preferably the conductive strips or bus bars are made of a durable material that can withstand the further processing conditions according to the method of this invention.

In preferred embodiments the conductive strips or bus bars are firmly bound and/or bonded to the photovoltaic device so that it does not separate during later processing steps or when the photovoltaic device is in service. Thus, in the process of this invention the conductive strip may be welded or soldered directly onto the metal back contact or is applied on a layer of said fritted conductive paste. Preferably the paste is subsequently heated or cured, e.g. in a furnace or oven at an elevated temperature, for example about 100° C to about 500° C for a time sufficient to cure the paste and form a conductive strip means.

In another embodiment of the invention the method further comprises a step of removing of unnecessary material from the edge regions of the photovoltaic device. As all the above-mentioned deposition steps have affected the whole area including the edges of the substrates deposited material will be present at these edges. These edge areas however will later be exposed to atmospheric conditions and therefore measures have to be taken in order to protect the cell structure against moisture, oxidation and/or delamination or alike. Therefore, unnecessary metal and semiconductor material is removed from said edge regions. This process may be performed by any suitably means. However, in a preferred embodiment a process called edge-scribing is carried out using a mechanical abrasion means, like sandblasting, grinding, shaving, water jet, CO₂ and/or other mechanical or chemical means. Alternatively optical methods, like laser ablation may be used.

Preferably, a narrow strip of the metal and other layers deposited are removed around the perimeter of the photovoltaic device to "edge-isolate" the photovoltaic device. The strip for the edge isolation is generally located about 0 cm to about 10cm from the edge of the device for most applications. Preferably, the removed strip is as small as possibly while providing sufficient space for isolation purposes. This has the advantage that as much surface area of the cell structure and, consequently, costs will be saved.

Preferably, a subsequent quality check step is carried out that may comprise a resistance measurement at high voltage and/or an optical system in order to detect remains of the coating(s). In a further quality check the I-V behaviour of the cell may be investigated, preferably by means of a Flasher. A fast time resolving measurement device allows characterizing the quality of the solar module.

In another embodiment of the invention the method further comprises the step of encapsulating of the photovoltaic device as the photovoltaic device should preferably be protected against later environmental influences such as moisture and/or oxygen. Any suitable material to protect the photovoltaic device from environmental influences can be used. Preferably the material forms a barrier to moisture and/or gas, such as oxygen.

In one preferred embodiment a foil is used to seal the photovoltaic device. More preferably said foil comprises ethylene vinyl acetate (EVA), polyvinylbutyral (PVB) or other suitable plastic material. Even more preferably, the foil is additionally colored to further enhance reflection. The foil can be chosen from commercially available products, especially in view of moisture permeability.

In a further embodiment a further encapsulation and thus protection against environmental influences will be achieved by a back substrate, preferably comprising glass and/or plastic. Such a back substrate will complete the sandwich of electrically conductive layers, semiconductor layers, reflectors, foils and electrical connecting means. Glass is preferred due to its availability, long-term-stability and barrier properties. More preferably, semi-tempered glass, tempered safety glass, chemically toughened glass and/or simple float glass can be used. The glass may be further coated or painted. Alternatively rigid plastic can be used as well as honey comb structures, e. g. based on carbon fibres. The joining of the photovoltaic sandwich structure may be carried out by lamination. Heat and pressure connect front and back glass during the lamination process.

In a preferred embodiment the back substrate will be inspected and/or undergo an edge seaming process before application to the photovoltaic device. Furthermore, contact holes can be drilled and/or a cleaning by rough washing can be carried out.

In another embodiment of the invention the method further comprises the step of cross-contacting the photovoltaic device. Cross-contacting is carried out to allow the electrical connection of the photovoltaic device to the outside world.

Cross-contacting is usually carried out by soldering and/or welding a conductor, such as flexible wires or ribbons, to the bus bars. Preferably, cross-contacting is achieved by leading said conductor through holes that have been introduced into the back substrate. Appropriate measures have to be taken in order provide for electrical insulation and environmental protection. As described above, the joining of the photovoltaic sandwich structure may be carried out by a lamination step. Heat and pressure connect front and back glass during the lamination process.

In a preferred embodiment a subsequent quality check is carried out to investigate, whether optically visible bubbles, thickness variation and/or mechanical module stress are within the specifications.

In a further embodiment an additional step is carried out to trim the edges in order to remove remains from the lamination process. The trimming step is preferably a mechanical trimming step.

In another embodiment of the invention control electronics, also known as J-Box, are applied to the photovoltaic device. In preferred embodiments such electronics comprise on-board inverters, control display means, function indicators, connecting points for electrical maintenance and/or connectors. The control electronics are preferably mounted at the back side of the photovoltaic device, covering the drilling holes. In another preferred embodiment the control electronics are mounted on the edges of the photovoltaic device, to result in a frame like structure.

In a further embodiment an additional quality check is carried out to ensure that the solar module exhibits the specified I-V values. Preferably, such a quality check is accomplished by means of a flashing station, exposing the solar module to a short-time light pulse while at the same time voltage and current are measured.

In another embodiment of the invention the method further comprises the step of framing the photovoltaic device. During the framing step the photovoltaic device is embedded in a frame in order to allow mounting it to any support structure. The framing is thus especially important if the photovoltaic device is to be used for architectural purposes. The frame can be of any suitable material, preferably comprising metal and/or plastic.

In a further embodiment an additional quality check is carried out to ensure that all international and/or national requirements for electrical safety are being met. Such a check is preferably carried out by a high potential test between photovoltaic device and frame.

In another embodiment of the invention the method further comprises the step of packing the photovoltaic device in order to allow safe transport and/or storage of the device.

For the purpose of this invention, individual blocks of processing or quality checks may change their order in order to optimize the process sequence.

In another preferred embodiment of the invention only the processing steps that require an elevated temperature are carried out at an elevated temperature with additional heating means and/or within a heat insulated area. It has been found that various steps according to the present invention, for example the laser scribing steps, the contacting, the cross-contacting, need not be carried out at an elevated temperature. In conventional systems an elevated temperature is maintained between the various processing steps in order to avoid several heating and cooling cycles. However, this has the disadvantage that additional efforts for the handling and transporting of the photovoltaic device are necessary. For example, all transport means have to be construed to withstand said elevated temperatures and areas, where service personnel have access to the processing environment must exhibit appropriate safety measures. Furthermore, all storage areas and transport paths have to be isolated in order to avoid heat losses.

In a preferred embodiment of the invention the substrate is stored and/or moved from one step of the method to the next step by means of a container. Even more preferably, more than one, i.e. a plurality of substrates is stored and/or moved by means of that container. In a more preferred embodiment the container is a cassette. The use of a container has the advantage that handling systems, transport systems and storage can be standardized so that the same transport and/or handling means can be used throughout the whole process, i.e. starting with the delivery of the substrate from the manufacturer to delivery of the completed and packed photovoltaic device. However, the loading of the substrate(s) into the container can take place between any two steps of the method according to the invention.

The container can have any suitable size to accommodate the substrate(s). Preferably, the container has a size to accommodate a substrate of 1.4 m², e.g. a substrate of the size 1.1m x 1.3 m.

The containers preferably allow collecting at least one substrate in a stacking means. Such stacking means allow arranging the substrate(s) in a vertical, horizontal and/or inclined manner.

In further preferred embodiments of the invention the container is construed to be automobile and/or is equipped with docking means allowing a defined interface e. g. to a handling system like a robot, a belt or handler.

In another preferred embodiment the container comprises means to protect the substrates from the environment, e.g. a removable enclosure and/or a lid.

In another aspect the present invention is directed to a system for the production of a thin-film photovoltaic device according to the method of the present comprising: Means for the deposition of at least a first semiconductor stack onto a substrate to produce a photovoltaic device; and optionally further comprising: Means for applying a back contact to the photovoltaic device; means for contacting the photovoltaic device; means for the removal of unnecessary material from the edge regions of the photovoltaic device; means for the encapsulation of the photovoltaic device; means for cross-contacting the photovoltaic device; and/or means for framing of the photovoltaic device, wherein the system further comprises means for the continuous or semi-continuous movement of the substrate from one means of the system to the next means of the system.

In another preferred embodiment of the invention all the source or sources of material being deposited are stationary and the substrate moves past the source continuously or more preferably discontinuously. This means that, e.g. the TCO layer(s) are deposited in n fractions of the total TCO layer thickness using n process stations/sources.

The further specific embodiments of the system will be apparent in light of the description regarding the method of the present invention above.

Further advantageous embodiments of the present invention are given in the dependent claims.

### Brief description of drawings

These and other aspects of the invention will be apparent from and elucidated with reference to the embodiments described hereinafter.

In the drawings:

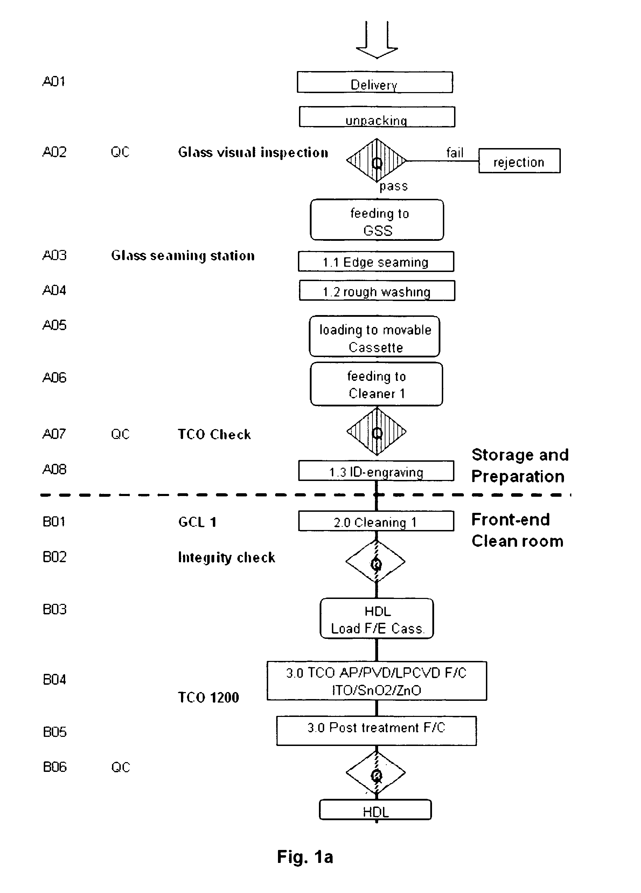

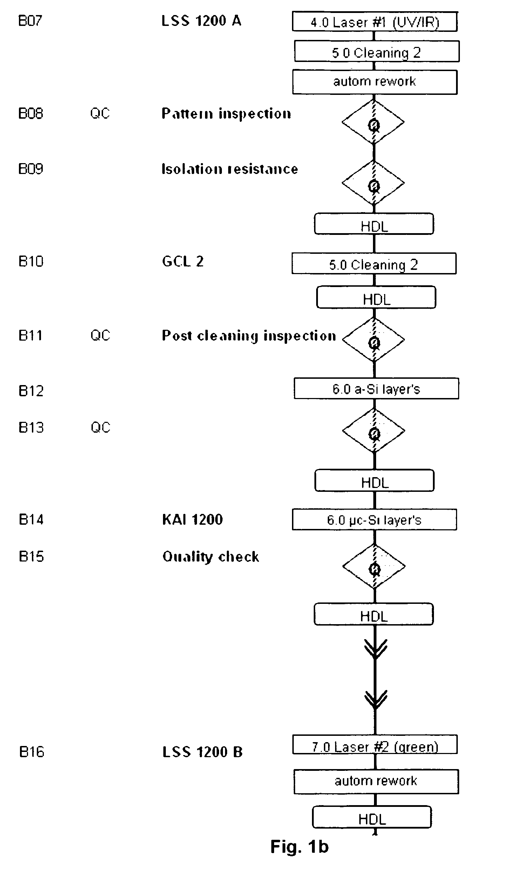

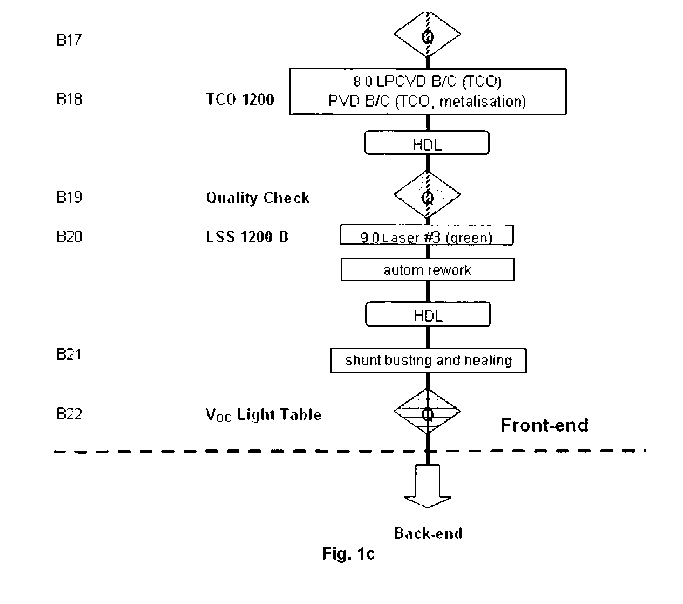

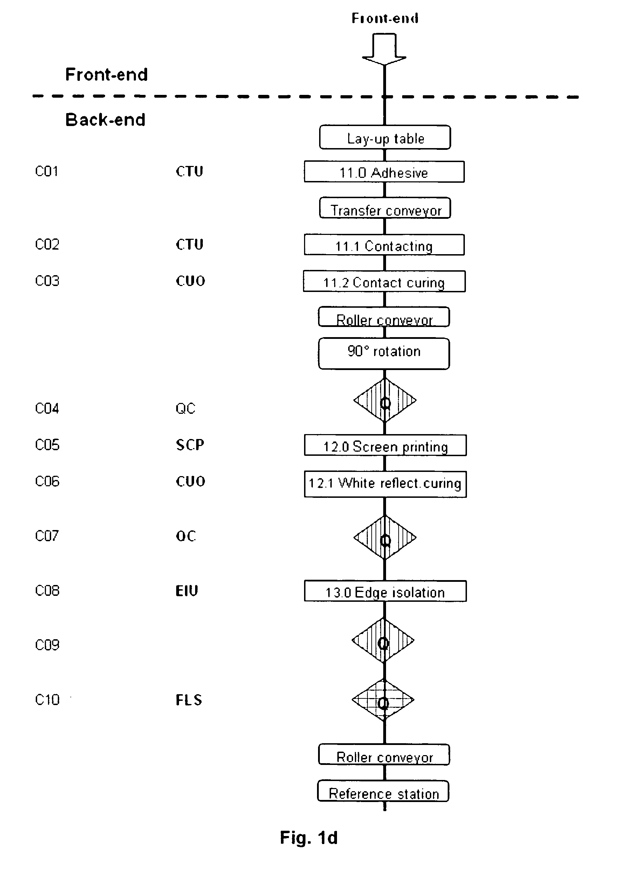

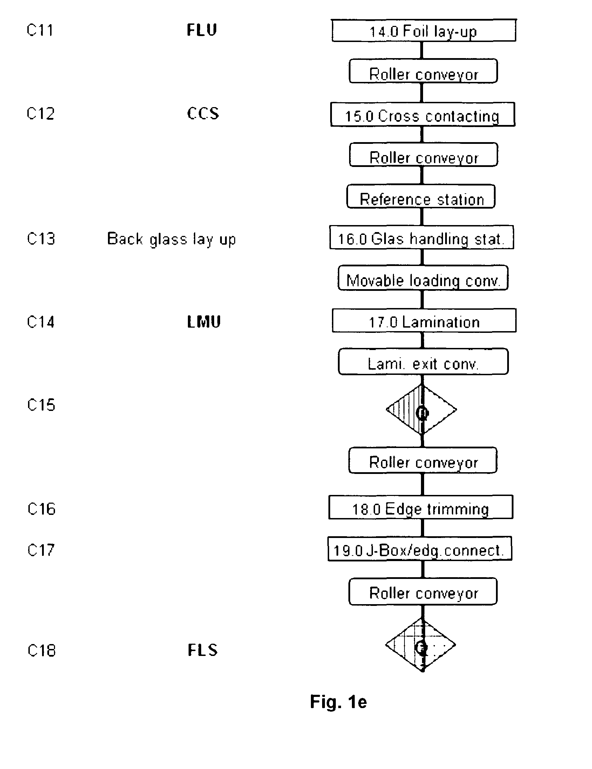

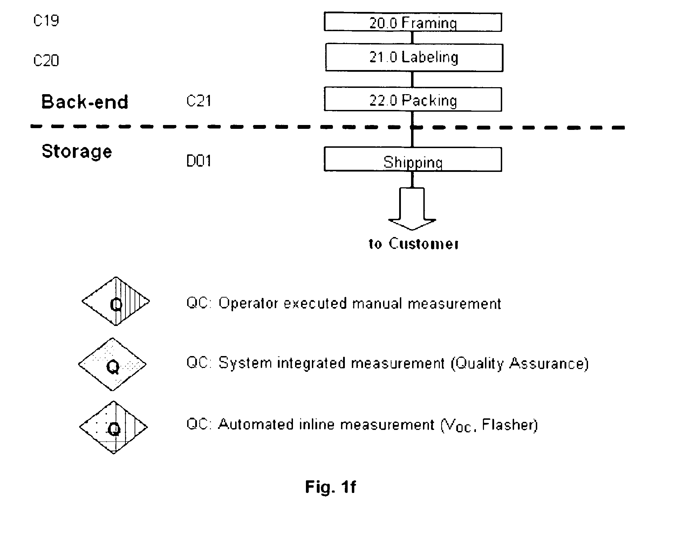

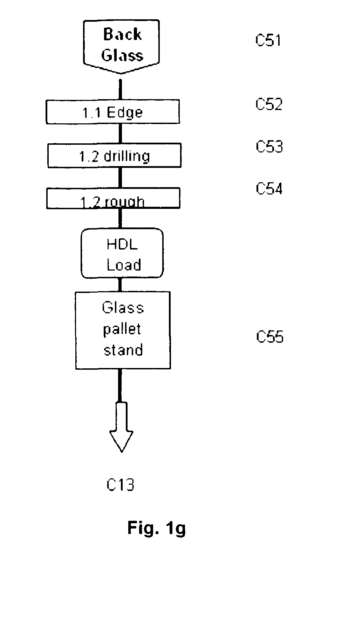

Fig. 1 shows a schematic representation of the steps carried out according to the method of the invention.

### Description of embodiments

Fig. 1 shows a schematic representation of the steps carried out in order to produce a photovoltaic device from glass as substrate material according to the method of the present invention.

The term "handling" as used herein summarizes all work steps taken to hold, grip, move or transport at least one substrate outside processing or treatment systems. Handling means comprise transport robots, wheels, belt systems, elevators, lifters, grippers and all other means useful for transporting substrate of the kind described. In the Figures Handling has been abbreviated by HDL.

A "quality check" in the sense of this invention comprises all work steps taken to compare the actual state of a substrate with an expected state. Quality checks comprise in situ measurements, control means and comparison of measurement data with target data. Quality checks can be performed as operator executed manual measurements, system integrated measurements and/or automated inline measurements. Although not expressly mentioned in this disclosure or shown in the figures, quality checks may be made for documentation reasons, to allow later correcting or reworking of substrates and/or to filter our defective substrates during all process steps.

"Cleaning steps" are required several times during the overall manufacturing process. If not pointed out specifically, cleaning substrates means work steps like washing, i.e. submerging in a bath, or spraying with solvents, water, water with additives such as detergents, de-ionized water and/or suitable etchants. Preferably, cleaning can be accompanied by ultrasonic cleaning. Mechanical means like brushes or webs may preferably be employed. Cleaning steps may also comprise stream of gas, like air, nitrogen or others (air knife). In vacuum environments cleaning is often performed by ion bombardment, i.e. glow discharge, etching gases and/or plasma assisted etching.

Heating of substrates takes place several times during the overall manufacturing process, depending on the respective process. The required temperatures vary between 150° C and 500° C. Heating may be accomplished under atmospheric conditions or under reduced pressure. Under atmospheric conditions an oven as known from the state of the art may be used, eventually with the aid of inert gases in order to avoid unwanted alterations of previously deposited layers. Under reduced pressure conditions radiation is preferred, e. g. by lamp heater elements. Preferably, the emission spectrum of such lamps is chosen to match one or several absorption bands of the substrate to be heated. Of course the substrate can also be placed on a heating element itself and be heated by said contact. Control of the desired temperature is being achieved by measures known in the art, such as pyrometer, infrared detectors or other temperature sensors.

Cooling of substrates may be necessary after certain process steps in order to allow further processing and/or handling. Cooling can be achieved passively by leaving substrates to cool down under ambient atmospheric conditions or by active measures like exposing them to a stream of gas or contacting them with a cooling plate.

The manufacturing process can be grouped into 4 blocks A-D. The preparing work is carried out in block A: Storage and Preparation. So called front end processes are carried out in block B, and back end processes are carried out in block C. Finally, in block D all subsequent steps, e.g. storage, are carried out.

The front end processes B comprise all steps starting with the bare, prepared substrate until and including the deposition of the photoelectric conversion layers and contact layers. The back end processes C subsequently following the front end processes describe all steps converting the result of the front end process into a solar module ready to be sold or mounted.

The references A01, B12, ... and so on, refer to the respective steps shown in the figures.

The method for the production of a photovoltaic device according to the present invention starts with the delivery and the unpacking of the glass substrate (A01). After a quality control (A02) to check for defects the substrate is then fed into the glass seaming station, where an edge seaming (A03) to provide for crack resistance and a rough washing (A04) is carried out.

In the next step (A05) a plurality of substrates is optionally transferred into movable containers and moved into a cleaner for a fine cleaning step (A06) before entering the front end clean room area.

If the substrate was delivered with a TCO deposited on it then a quality check of the TCO (A07) is additionally carried out.

In a next step (A08) an ID is engraved onto every substrate for identification purposes.

The containers comprising the substrates are then moved on to block B for the deposition of the photoelectric conversion layers and contact layers.

The substrates are washed and dried (B01), followed by a further quality check (B02) to ensure that the glass substrates are clean, without scratches or pinholes before the front contact is applied. If not already carried out in step A05 a plurality of the cleaned and inspected substrates is loaded into a front end cassette system for transport (B03).

In Step B04 the TCO front contact layer is deposited in case no pre-coated TCO glass is used. The front contact comprises zinc oxide and is deposited by LPCVD to a thickness of 1 µm to 2 µm. The textured front contact morphology is achieved by a deposition rate of about 2 nm per second to about 4 nm per second, a temperature of about 100° C to about 300° C and at a pressure of about 0.2hPa to about 2hPa.

If other deposition parameters are used then the morphology of the TCO layer is achieved by post-treatment steps (B05) using an acid etch process such as by exposing the TCO layer to a diluted aqueous solution of hydrofluoric acid at a concentration of about 0.1 to about 1 weight percent acid, for about 15 to about 20 seconds, at about room temperature followed by a thorough rinsing with water to remove residual acid.

After application of the TCO layer and a possible its post-treatment (B04/B05) a quality check B06 ensures that values haze, thickness and resistivity for the TCO layer are within the specifications.

Further handling transfers the inspected substrates comprising the TCO a first laser treatment module, where the front contact is divided or patterned to provide for a collection of individual photovoltaic cells (B07). After laser ablation, i.e. the laser scribe, of parallel stripes, each about 20 µm to about 50 µm wide, a cleaning step and automatic reworking are carried out together with quality control (B08).

A further quality check B09 measures the resistance between two patterned areas, i.e. if the laser scribe achieved its goal to electrically insulate the respective cell areas.

The next deposition step in the process is to apply an amorphous silicon-containing thin film semiconductor. In order to perform this step on an again perfectly clean substrate surface, a glass cleaning step B10 is performed followed by a post cleaning inspection B11, where especially the cleanliness between the patterned areas is being checked, since these areas will be coated again in the following steps.

In the next step the a-Si p-i-n layer is deposited by PECVD (B12), followed by a subsequent quality check (B13), wherein thickness uniformity and shunts are investigated according to the specification.

In the following step the µ-Si p-i-n junction is deposited using a KAI 1200 PECVD (B14) and a subsequent quality check B15 is carried out to determine thickness uniformity and shunts according to the specification.

The next step (B16) enables the later contacting between the patterned front contact and the later applied back contact by removing all layers except for the front contact in a strip- or point-like pattern. This step is carried out by a second laser patterning module to perform the so-called pattern 2 scribe of the semiconductor layer stack.

The quality check B17 allows controlling the accuracy of the pattern scribed and the pass/fail result will be used for rework-measures if possible.

The ZnO TCO back contact is applied in step B18 using the TCO 1200 LPCVD system as supplied by Oerlikon Solar. The process parameters are those of process step B04. A subsequent quality check B19 examines the conformity of the TCO with the specification.

A third laser patterning step B20 is carried out to remove strips of the back contact and the silicon layers parallel to the strips formed in the front contact. Control of and cleaning during/after of the patterning step is achieved as described for the previous patterning steps.

The shunt busting and healing step is subsequently carried out (B21) to cure shunts.

The last check of the front-end processes of block B is a quality check (B22), wherein the open circuit voltage is measured using a light table.

The containers comprising the substrates are now transported on to block C, i.e. the back end processing.

If the back contact is a TCO, a silver glue is dispensed onto the photovoltaic devices (C01). Afterwards a conductive copper stripes are applied to the glue (C02). If, alternatively, a fritted conductive paste is used, a curing step (C03) is carried out.

A subsequent quality check C04 comprises a visual inspection, if any lift-ups of the contact ribbon can be detected due to incomplete contacting.

In the following step (C05) a reflector is deposited by a screen printing method and subjected to a curing step (C06) by application of UV light in order to accelerate processing. A subsequent visual quality check (C07) ensures that the specification in terms of reflectance, positioning of the reflector and its optical density are being met.

An edge scribing step (C08) by mechanical abrasion is carried out to remove a narrow strip of the deposited layers, followed by a subsequent quality check (C09) that comprises a resistance measurement at high voltage and/or an optical system in order to detect remains of the coating(s). A further quality check (C10) investigates the I-V behavior of the cell by means of a Flasher. A fast time resolving measurement device allows characterizing the quality of the solar module.

An ethylene vinyl acetate foil is applied for encapsulation of the photovoltaic device (C11), followed by the mounting of a back glass. Said glass will, after delivery (C51) and inspection optionally undergo an edge seaming process (C52). Furthermore, contact holes can be drilled (C53) and a cleaning by rough washing can be carried out (C54). The back glass prepared in this way is stored (C55) until usage in steps C12 and C13.

In the next step a cross-contacting is achieved by directing flexible wires through the holes in the back glass (C12). In step C13 the back glass is arranged in close relationship to the cell structure on the front glass and the foil. The joining of said elements takes place by lamination (C14) in a lamination module. A subsequent quality check (C15) is carried out to examine, whether optically visible bubbles, thickness variation and mechanical module stress are within the specifications.

In process step C16 the edges are mechanically trimmed in order to remove remains from the lamination process and control electronics are mounted to the photovoltaic device (C17).

Again, a Quality Check (C18) performed by means of a flashing station ensures that the photovoltaic device exhibits the specified I-V values.

The photovoltaic device is framed (C19) with a plastic frame in order to allow mounting to a support structure. An optional high potential test between module and frame may further be carried out.

The photovoltaic device may then be labeled (C20) and subjected to a packing step (C21) in order to allow safe transporting and storing of the photovoltaic devices. This transporting and storing is addressed in D01.

While the invention has been illustrated and described in detail in the drawings and foregoing description, such illustration and description are to be considered illustrative or exemplary and not restrictive; the invention is not limited to the disclosed embodiments. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

## Claims

1. A method for the production of a thin-film photovoltaic device, comprising the steps of:
a) Providing at least one substrate comprising a front contact;
b) Depositing at least a first semiconductor stack onto the substrate to produce a photo-voltaic device;
and comprising at least two of the steps of:
c) Applying a back contact to the photovoltaic device;
d) Contacting of the photovoltaic device;
e) Removal of unnecessary material from the edge regions of the photovoltaic device;
f) Encapsulation of the photovoltaic device;
g) Cross-contacting the photovoltaic device; and/or
h) Framing of the photovoltaic device,
wherein the substrate is continuously or semi-continuously moved from one step of the method to the next step of the method, and a plurality of substrates is simultaneously moved by means of a container.

2. The method according to claim 1, wherein the thin-film photovoltaic device is a tandem thin-film photovoltaic device and at least a first and a second semiconductor stack are de-posited in step b), wherein the first semiconductor stack is an amorphous semiconductor stack and the second semiconductor stack is a microcrystalline semiconductor stack.

3. The method according to claim 1, wherein the container is provided as a cassette.

4. The method according to claim 1, wherein the container is automobile, comprises docking means providing a defined interface and/or comprises means for the protection of the substrate.

5. The method according to claim 1, wherein step a) further comprises an optional deposition of a dielectric and the deposition of at least one textured transparent conductive oxide (TCO) layer to provide a front contact.

6. The method according to claim 5, wherein n > 1 TCO layers are discontinuously deposited in n separate steps.

7. The method according to claim 5 or 6, wherein the TCO layer is deposited at a rate of 2-4 nm/s.

8. The method according to claim 1, wherein the back contact in step c) is a TCO layer or a metallic back contact.

9. The method according to claim 8, wherein the back contact is a TCO layer, further comprising applying a back reflector.

10. The method according to claim 1, wherein the front contact of step a), the at least first semiconductor stack of step b) and/or the back contact of step c) is patterned by use of a laser.

11. The method according to claim 10, wherein the laser treatment is carried out at ambient temperature.

12. The method according to claim 1, wherein the encapsulation of step f) is carried out by application of a sealing foil and/or application of a back glass.

13. The method according to claim 1, wherein a cleaning step of the substrate and/or the photovoltaic device is carried out before and/or after any of the steps a) through h).

14. The method according to claim 1, wherein the substrate and/or photovoltaic device is subjected to a quality check before and/or after any of the steps a) through h).

15. A system for the production of a thin-film photovoltaic device according to the method of claims 1-14, comprising:
a) Means for the deposition of at least a first semiconductor stack onto a substrate to produce a photovoltaic device;
and optionally further comprising:
b) Means for applying a back contact to the photovoltaic device;
c) Means for contacting the photovoltaic device;
d) Means for the removal of unnecessary material from the edge regions of the photovoltaic device;
e) Means for the encapsulation of the photovoltaic device;
f) Means for cross-contacting the photovoltaic device; and/or
g) Means for framing of the photovoltaic device,
wherein the system further comprises means for the continuous or semi-continuous movement of the substrate from one means of the system to the next means of the system, and a plurality of substrates is simultaneously moved by means of a container.

## Patentansprüche

1. Verfahren zum Herstellen einer Dünnschicht-Photovoltaikvorrichtung mit den Schritten:
a) Bereitstellen mindestens eines Substrats mit einem Frontkontakt;
b) Aufbringen mindestens eines ersten Halbleiterstapels auf das Substrat zum Herstellen einer Photovoltaikvorrichtung; und
mit mindestens zwei der folgenden Schritte:
c) Aufbringen eines Rückkontakts auf die Photovoltaikvorrichtung;
d) Kontaktieren der Photovoltaikvorrichtung;
e) Entfernen von unnötigem Material von den Randbereichen der Photovoltaikvorrichtung;
f) Verkapseln der Photovoltaikvorrichtung;
g) Querkontaktieren der Photovoltaikvorrichtung; und/oder
h) Einrahmen der Photovoltaikvorrichtung,
wobei das Substrat von einem Verfahrensschritt zum nächsten Verfahrensschritt kontinuierlich oder halbkontinuierlich bewegt wird, und wobei mehrere Substrate unter Verwendung eines Behälter gleichzeitig bewegt werden.

2. Verfahren nach Anspruch 1, wobei die Dünnschicht-Photovoltaikvorrichtung eine Tandem-Dünnschicht-Photovoltaikvorrichtung ist, und wobei in Schritt b) mindestens ein erster und ein zweiter Halbleiterstapel aufgebracht werden, wobei der erste Halbleiterstapel ein amorpher Halbleiterstapel ist und der zweite Halbleiter ein mikrokristalliner Halbleiterstapel ist.

3. Verfahren nach Anspruch 1, wobei der Behälter als eine Kassette bereitgestellt wird.

4. Verfahren nach Anspruch 1, wobei der Behälter selbstfahrend ist, eine Docking-Einrichtung aufweist, die eine definierte Schnittstelle bereitstellt, und/oder eine Einrichtung zum Schützen des Substrats aufweist.

5. Verfahren nach Anspruch 1, wobei Schritt a) ferner das optionale Aufbringen eines Dielektrikums und das Aufbringen mindestens einer strukturierten transparenten leitfähigen Oxid(TCO)schicht zum Bereitstellen eines Frontkontakts aufweist.

6. Verfahren nach Anspruch 5, wobei n > 1 TCO-Schichten in n getrennten Schritten diskontinuierlich aufgebracht werden.

7. Verfahren nach Anspruch 5 oder 6, wobei die TCO-Schicht mit einer Rate von 2-4 nm/s aufgebracht wird.

8. Verfahren nach Anspruch 1, wobei der in Schritt c) aufgebrachte Rückkontakt eine TCO-Schicht oder ein metallischer Rückkontakt ist.

9. Verfahren nach Anspruch 8, wobei der Rückkontakt eine TCO-Schicht ist, und ferner mit dem Schritt zum Aufbringen eines rückseitigen Reflektors.

10. Verfahren nach Anspruch 1, wobei der in Schritt a) aufgebrachte Frontkontakt, der in Schritt b) aufgebrachte mindestens erste Halbleiterstapel und/oder der in Schritt c) aufgebrachte Rückkontakt unter Verwendung eines Lasers strukturiert werden.

11. Verfahren nach Anspruch 10, wobei die Laserbehandlung bei Umgebungs-temperatur ausgeführt wird.

12. Verfahren nach Anspruch 1, wobei die Verkapselung in Schritt f) durch Aufbringen einer Dichtungsfolie und/oder Aufbringen eines rückseitigen Glases ausgeführt wird.

13. Verfahren nach Anspruch 1, wobei vor und/oder nach irgendwelchen der Schritte a) bis h) ein Reinigungsschritt zum Reinigen des Substrats und/oder der Photovoltaikvorrichtung ausgeführt wird.

14. Verfahren nach Anspruch 1, wobei das Substrat und/oder die Photovoltaikvorrichtung vor und/oder nach irgendwelchen der Schritte a) bis h) einer Qualitätsprüfung unterzogen wird.

15. System zum Herstellen einer Dünnschicht-Photovoltaikvorrichtung gemäß einem Verfahren nach einem der Ansprüche 1 - 14, mit:
a) einer Einrichtung zum Aufbringen mindestens eines ersten Halbleiterstapels auf ein Substrat zum Herstellen einer Photovoltaikvorrichtung;
und optional ferner mit:
b) einer Einrichtung zum Aufbringen eines Rückkontakts auf die Photovoltaikvorrichtung;
c) einer Einrichtung zum Kontaktieren der Photovoltaikvorrichtung;
d) einer Einrichtung zum Entfernen von unnötigem Material von den Randbereichen der Photovoltaikvorrichtung;
e) einer Einrichtung zum Verkapseln der Photovoltaikvorrichtung;
f) einer Einrichtung zum Querkontaktieren der Photovoltaikvorrichtung; und/oder
g) einer Einrichtung zum Einrahmen der Photovoltaikvorrichtung,
wobei das System ferner eine Einrichtung zum kontinuierlichen oder halbkontinuierlichen Bewegen des Substrats von einer Einrichtung des Systems zur nächsten Einrichtung des Systems aufweist, und wobei mehrere Substrate unter Verwendung eines Behälters gleichzeitig bewegt werden.

## Revendications

1. Procédé pour la production d'un dispositif photovoltaïque à couche mince, comprenant les étapes suivantes :
a) mise à disposition d'au moins un substrat comprenant un contact avant ;
b) dépôt d'au moins une première pile de semiconducteurs sur le substrat, pour produire un dispositif photovoltaïque ;
c) application d'un contact arrière sur le dispositif photovoltaïque ;
d) mise en contact du dispositif photovoltaïque ;
e) retrait de la matière inutile sur les régions de bord du dispositif photovoltaïque ;
f) encapsulation du dispositif photovoltaïque ;
g) mise en contact croisée du dispositif photovoltaïque ; et/ou
h) encadrement du dispositif photovoltaïque ;
dans lequel le substrat est déplacé de manière continue ou semi-continue d'une étape de procédé vers la prochaine étape de procédé, et une pluralité de substrats est déplacée simultanément au moyen d'un conteneur.

2. Procédé selon la revendication 1, dans lequel le dispositif photovoltaïque à couche mince est un dispositif photovoltaïque à couche mince en tandem, et au moins une première et une deuxième pile de semiconducteurs sont déposées dans l'étape b), dans lequel la première pile de semiconducteurs est une pile de semiconducteurs amorphes, et la deuxième pile de semiconducteurs est une pile de semiconducteurs microcristallins.

3. Procédé selon la revendication 1, dans lequel le conteneur est conçu comme une cassette.

4. Procédé selon la revendication 1, dans lequel le conteneur est automobile, comprend des moyens d'accrochage fournissant une interface définie et/ou comprend des moyens pour la protection du substrat.

5. Procédé selon la revendication 1, dans lequel l'étape a) comprend en outre un dépôt facultatif d'un diélectrique et le dépôt d'au moins une couche d'oxyde conductrice (TCO), transparente et texturée, pour fournir un contact avant.

6. Procédé selon la revendication 5, dans lequel n>1 couches de TCO sont déposées de manière discontinue, en n étapes séparées.

7. Procédé selon la revendication 5 ou 6, dans lequel la couche de TCO est déposée à la vitesse de 2-4 nm/s.

8. Procédé selon la revendication 1, dans lequel le contact arrière dans l'étape c) est une couche de TCO ou un contact arrière métallique.

9. Procédé selon la revendication 8, dans lequel le contact arrière est une couche de TCO, comprenant en outre l'application d'un réflecteur arrière.

10. Procédé selon la revendication 1, dans lequel le contact avant de l'étape a), l'au moins une première pile de semiconducteurs de l'étape b) et/ou le contact arrière de l'étape c) sont gravés au laser.

11. Procédé selon la revendication 10, dans lequel le traitement laser est exécuté à température ambiante.

12. Procédé selon la revendication 1, dans lequel l'encapsulation de l'étape f) est exécutée par application d'une feuille d'étanchéité et/ou par application d'un verre arrière.

13. Procédé selon la revendication 1, dans lequel une étape de nettoyage du substrat et/ou du dispositif photovoltaïque est exécutée avant et/ou après l'une quelconque des étapes a) à h).

14. Procédé selon la revendication 1, dans lequel le substrat et/ou le dispositif photovoltaïque est soumis à un contrôle qualité avant et/ou après l'une quelconque des étapes a) à h).

15. Système pour la production d'un dispositif photovoltaïque à couche mince selon le procédé des revendications 1-14, comprenant :
a) des moyens pour le dépôt d'au moins une première pile de semiconducteurs sur le substrat, pour produire un dispositif photovoltaïque ;
b) des moyens pour l'application d'un contact arrière sur le dispositif photovoltaïque ;
c) des moyens pour la mise en contact du dispositif photovoltaïque ;
d) des moyens pour le retrait de la matière inutile sur les régions de bord du dispositif photovoltaïque ;
e) des moyens pour l'encapsulation du dispositif photovoltaïque ;
f) des moyens pour la mise en contact croisée du dispositif photovoltaïque ; et/ou
g) des moyens pour l'encadrement du dispositif photovoltaïque,
dans lequel le système comprend en outre des moyens pour le déplacement continu ou semi-continu du substrat, d'un moyen du système vers le prochain moyen du système, et une pluralité de substrats est déplacée simultanément au moyen d'un conteneur.
